# EUROPÄISCHE PATENTSCHRIFT

(11) **EP 1 314 172 B1**
(45) Veröffentlichungstag und Bekanntmachung des Hinweises auf die Patenterteilung: **20.04.2005**
(21) Anmeldenummer: 01960431.3
(22) Anmeldetag: 30.06.2001
(51) Int. Cl.: H01C 17/065

(54) **VERFAHREN ZUR HERSTELLUNG EINES MASSEREICHEN OHMSCHEN WIDERSTANDS ZUM SURGESCHUTZ VON ELEKTRONISCHEN BAUEINHEITEN UND ELEKTRONISCHE BAUEINHEIT**
METHOD FOR PRODUCING A LARGE-MASS OHMIC RESISTOR FOR PROTECTING ELECTRONIC ASSEMBLIES FROM SURGES, AND AN ELECTRONIC ASSEMBLY
PROCEDE DE FABRICATION D'UNE RESISTANCE OHMIQUE MASSIQUE POUR LA PROTECTION CONTRE LES POINTES D'ENERGIE DE MODULES ELECTRONIQUES, ET MODULE ELECTRONIQUE Y RELATIF

(30) Priorität: 31.08.2000 DE 10042764
(43) Veröffentlichungstag der Anmeldung: 28.05.2003
(73) Patentinhaber: Moeller GmbH, 53115 Bonn (DE); Schmitz, Gerd, 53844 Troisdorf (DE)
(72) Erfinder: SCHMITZ, Gerd, 53844 Troisdorf (DE)
(74) Vertreter: Mäder, Winfried
(86) Internationale Anmeldenummer: PCT/EP2001/007505
(87) Internationale Veröffentlichungsnummer: WO 2002/019349

(56) Entgegenhaltungen:
- US-A- 5 557 252
- US-A- 5 734 314
- SERA N ET AL: "Thin panel switch with LED for cellular telephones" NATIONAL TECHNICAL REPORT, AUG. 1996, MATSUSHITA ELECTRIC INDUSTRIAL CO, JAPAN, Bd. 42, Nr. 4, Seiten 50-56, XP001039992 ISSN: 0028-0291
- PATENT ABSTRACTS OF JAPAN vol. 1998, no. 14, 31. Dezember 1998 (1998-12-31) -& JP 10 247769 A (SONY CORP), 14. September 1998 (1998-09-14)

## Beschreibung

Die Erfindung betrifft ein Verfahren zur Herstellung eines massereichen ohmschen Widerstands zum Surgeschutz von elektronischen Baueinheiten sowie eine derartige elektronische Baueinheit mit Mitteln zum Schutz vor Stossspannuhgs-, beziehungsweise Stossstromimpulsen gemäß dem Oberbegriff der unabhängigen Ansprüche.

Bei elektronischen Baugruppen (EBE) ist, um eine Zerstörung der Bauelemente zu vermeiden, ein Schutz gegen energiereiche Überspannungsspitzen erforderlich.

In der IEC1000-4-5 zum Nachweis der Störfestigkeit gegen Stoßspannungen sind die Grenzwerte und die Kurvenformen für entsprechende Prüfungen angegeben. Üblich sind, je nach der geforderten Überspannungskategorie der elektronischen Baueinheiten (EBE), Prüfpegel von 0,5 bis 4kV oder höher. Der Stoßspannungsimpuls (Surgebeanspruchung) hat im unbelasteten Zustand einen doppelt exponentiellen Kurvenverlauf mit einer Stimzeit von 1,2 µs und einer Rückenhalbwertszeit von 50 µs. Dabei ist die Stimzeit als die Anstiegszeit eines Stoß(spannungs)impulses von 10 % auf 90 % seines Amplitudenscheitelwertes definiert. Die Rückenhalbwertzeit dagegen ist definiert als die Zeit des Stoß(spannungs)impulses vom Maximum (100%) des Amplitudenscheitelwertes bis auf 50% desselben.

Als Innenwiderstand des Stoßgenerators ist bei Prüfungen auf die Versorgungsleitungen (Line to Line) ein Widerstand von 2 Ω vorgegeben.

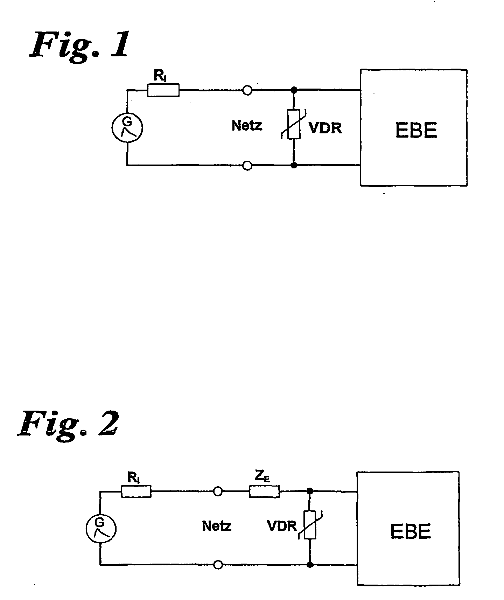

Im allgemeinen ist es nicht möglich, die Bauelemente für eine solche Überspannung auszulegen. Es ist daher üblich, mittels spannungsbegrenzender Bauelemente, z.B. durch Varistoren oder Suppressordioden, die parallel zur Baugruppe geschaltet werden, die Spannung an der elektronischen Baugruppe zu begrenzen (Figur 1). Aufgrund des geringen Innenwiderstandes des Prüfgenerators fließen dabei über das spannungsbegrenzende Schutzelement sehr große Ströme. Dabei muß eine sehr große Impulsenergie absorbiert werden. Um einen hohen Schutzpegel zu erreichen, ist daher der Einsatz eines relativ großen, voluminösen Varistors mit einem entsprechenden Absorptionsvermögen erforderlich. Des Weiteren steigt die Clamping-Spannung, d.h. die durch das Schutzelement begrenzte Spannung, in Abhängigkeit von der Nichtlinearitätskomponente des Schutzelements und der Höhe des Stromimpulses an.

Als Beispiel ergibt sich in einer Anwendung mit einem 275 V-Varistor bei einer Impulsspannung von 4 kV bei einer Phasenlage von 90° zur Netzspannung ein maximaler Impulsstrom von ca. 1700 A, wobei sich eine Clamping-Spannung von max. 900 V einstellt. Da nach der IEC1000-4-5 eine Impulsfolge von zwanzig Impulsen im Abstand von sechzig Sekunden gefordert werden, ist bei dieser Belastung ein Varistor mit einem minimalen Durchmesser von 14 mm erforderlich. Bei Geräten mit geringem Leistungsbedarf ist es daher allgemein üblich, zur Reduzierung der Impulsströme die Eingangsimpedanz der EBE durch einen Längswiderstand zu erhöhen (Figur 2). Bei einer Eingangsimpedanz von ca. 50 Ω wird der Impulsstrom bei dem oben genannten Beispiel auf einen Wert von max. 70 A begrenzt. Dadurch ergibt sich einerseits eine geringere Clamping-Spannung von maximal 750 V, andererseits kann hier der Varistor auf einen Scheibendurchmesser von 5 mm reduziert werden. Hierdurch ist auch der Einsatz von Varistoren in SMD-Technik (surface mounted device) möglich, die derzeit nur bis zu einer maximalen Impulsbelastbarkeit von 1200 A (einmaliger Impuls) hergestellt werden.

Nachteilig hierbei ist, dass für den Vorwiderstand ein Widerstand mit sehr großer Impulsfestigkeit verwendet werden muß. Bei dem oben genannten Beispiel muß der Widerstand einer Impulsleistung von ca. 240 kW widerstehen.

Modeme Widerstände in Schichttechnologie sind jedoch für eine solche Impulsbelastung ungeeignet. Kohlemassewiderstände, die eine ausgezeichnete Impulsfestigkeit besitzen, werden derzeit so gut wie nicht mehr gefertigt. Als Vorwiderstand eignen sich daher nur Drahtwiderstände. Für das oben genannte Beispiel ist jedoch je nach Widerstandstyp eine Baugröße mit einer Nennleistung von minimal 4 Watt erforderlich. Diese Widerstände besitzen jedoch ein sehr großes Bauvolumen und sind nur in bedrahteter Ausführung verfügbar. Des Weiteren ist hier der Kostenaufwand größer als bei der Verwendung eines größeren Varistors für ein "hartes Clamping", d.h. für eine Schutzbeschaltung ohne zusätzlichen Vorwiderstand.

Mit SMD-Drahtwiderständen, die derzeit mit einer maximalen Nennleistung von 2,5 W gefertigt werden, ist eine Surgebeanspruchung von maximal 2 kV zu erreichen.

Des Weiteren ist aus der Druckschrift "National Technical Report" - Thin panel switch", August 1996, Matsushita Electric Industrial Co, Japan, Bd. 42, Nr. 4, Seiten 50-56 die allgemeine Verwendung von gedruckten Vorwiderständen für LED's bekannt.

Der Erfindung liegt die Aufgabe zugrunde, ein Verfahren zur Herstellung eines massereichen Widerstands sowie eine elektronische Baugruppe zu schaffen die bei entsprechender Surgebelastung eine kleinere Baugrösse gewährleistet.

Ausgehend von Baueinheiten der eingangs genannten Art wird die Aufgabe erfindungsgemäß durch die kennzeichnenden Merkmale der unabhängigen Ansprüche gelöst, während den abhängigen Ansprüchen vorteilhafte Weiterbildungen der Erfindung zu entnehmen sind.

Durch das erfindungsgemäße Herstellungsverfahren wird ein massereicher ohmscher Widerstand hoher Impulsfestigkeit geschaffen, der eine kleine Baugrösse gewährleistet. Hierfür wird eine Widerstandsschicht, insbesondere eine Carbonschicht, auf eine Leiterplatte zwischen zwei Anschlusspads aufgebracht. Dies geschieht mit Vorteil im Siebdruckverfahren. Vorzugsweise wird die Widerstandsschicht im Mehrlagendruck erstellt. Nach dem Aufbringen der Widerstandsschicht wird diese eingebrannt und so auf dem Träger (Leiterplatte) fixiert. Carbondrucke werden bislang lediglich zur Substitution von Gold an Kontaktstellen oder zur Herstellung von kreuzenden Leiterbahnen (cross-over) eingesetzt.

Um eine Querschnittsverminderung an den Verbindungs-, beziehungsweise Übergangsstellen zwischen Widerstandsschicht und Anschlusspad(s) zu vermeiden, kann der Bereich der Leiterplatte zwischen den Anschlusspads im Bereich der aufzubringenden Widerstandsschicht mit einer Füllschicht versehen werden. Auf diese Weise wird eine ebene Trägeroberfläche für die Widerstandsschicht geschaffen. Ein stufenartiger Übergangsbereich im Randbereich der Anschlusspads wird so vermieden. Eine weitere Möglichkeit, einen solchen Übergangsbereich zu optimieren, kann realisiert werden, indem die Anschlusspads in z.B. vorgefräste Ausnehmungen der Leiterplatte eingebettet werden. Auch hierdurch wird eine ebene Trägeroberfläche für die Widerstandsschicht erzielt.

Die erfindungsgemäße elektronische Baueinheit bildet die Baugruppe für elektrische Geräte mit einer Leistungsaufnahme von vorzugsweise kleiner 10 VA, so dass die Verlustleistung im Vorwiderstand bei Nennbetrieb vemachlässigbar klein bleibt (bei 10 VA, 230 V und Rv = 50 Ω ist Pv < 0,1 W). Insbesondere eignet sich die Baugruppe für Schütze kleinerer Leistung, Zeitrelais und dergleichen. Dabei ist die Baueinheit durch ein Trägerelement in Form einer Leiterplatte mit darauf bzw. darin befindlichen Leiterbahnen und Anschlusspads zum Anschluß von Bauelementen ausgebildet, wobei die Leiterplatte vorzugsweise einseitig mit einer Widerstandsschicht versehen ist und anderseitig der gewünschten Schaltungsfunktion entsprechende Bauelemente umfasst. Die Widerstandsschicht ist vorzugsweise wie vorstehend beschrieben als Carbonschicht ausgeführt. Die Bauteile umfassen Halbleiterbauelemente und zumindest einen als Vorwiderstand wirkenden ohmschen Widerstand. Dieser Vorwiderstand wird durch die "rückseitige" (auf Rückseite der Leiterplatte angeordnete) Widerstandsschicht gebildet. Diese ist auf die Vorderseite durchkontaktiert und wird hier in die elektronische Schaltung als Vorwiderstand zur Begrenzung von impulsförmigen Eingangsströmen verschaltet. Auf diese Weise wird die elektronische Schaltung vor energiereichen Eingangsspannungs- bzw. Eingangsstromspitzen wirksam geschützt.

Weitere Einzelheiten und Vorteile der Erfindung ergeben sich aus den folgenden, anhand von Figuren erläuterten Ausführungsbeispielen. Es zeigen
- Figur 1:: eine erste mögliche Eingangsbeschaltung einer elektronischen Baueinheit nach dem Stand der Technik;
- Figur 2:: eine weitere mögliche Eingangsbeschaltung einer elektronischen Baueinheit nach dem Stand der Technik;
- Figur 3:: eine elektronische Baueinheit gemäß der Erfindung;
- Figur 4:: eine Detailansicht gemäß Fig. 3;
- Figur 5:: eine weitere Detailansicht gemäß Fig. 3;
- Figur 6a-c:: eine Draufsicht auf den Schichtwiderstand gemäß Fig. 3-5 und
- Fig. 7:: eine weitere Draufsicht gemäß Fig. 3-5.

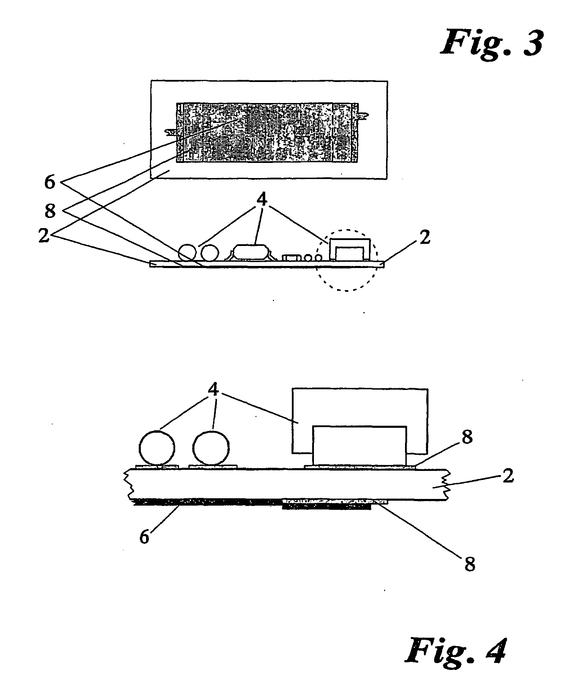

Nach Fig. 3 umfasst die erfindungsgemäße elektronische Baueinheit eine Leiterplatte 2, diverse Bauelemente 4 wie Halbleiter sowie aktive und passive Bauelemente. Zum Schutz der Bauelemente 4 insbesondere der empfindlichen Halbleiter weist die elektronische Baueinheit eingangsseitig einen Vorwiderstand 6 auf. Der Vorwiderstand 6 ist vorzugsweise zu mindestens einem der Eingangsanschlüsse (Eingangsklemmen) in Serie geschaltet. Gemäß der Erfindung ist dieser Vorwiderstand 6 in Form einer ohmschen Widerstandsschicht, insbesondere eine Carbonschicht, ausgebildet. Vorzugsweise ist die Widerstandsschicht mehrlagig ausgeführt und ggf. mit Isolierpasten zur Erzielung des gewünschten Widerstandswertes abgemischt. Die Widerstandsschicht ist vorzugsweise als Carbonlack (z.B. 1-Komponenten Carbonlack SD 2841 HAL bzw. SD 2841 HAL-BW der Fa. Lackwerke Peters) ausgebildet und mit Vorteil im Siebdruckverfahren auf die Leiterplatte 2 aufgedruckt und anschließend eingebrannt. Durch die Mehrfachbedruckung kann die Schichtstärke des Widerstandes 4 und damit die Impulsfestigkeit erhöht werden. Mit Vorteil wird eine Leiterplattenseite ausschließlich mit den Bauelementen 4 bestückt während die andere Leiterplattenseite für die Bedruckung mit der Widerstandsschicht vorgesehen ist. Hierdurch wird eine kleine Bauweise einer derartigen Baueinheit gewährleistet. Zum Zwecke der Verschaltung des Vorwiderstandes 6 (Widerstandsschicht) werden Anschlusspads 8 beider Leiterplattenseiten in bekannter Weise durchkontaktiert.

Um eine Querschnittsverminderung an den Verbindungs-, beziehungsweise Übergangsstellen zwischen Widerstandsschicht und Anschlusspad(s) 8 zu vermeiden, kann der Bereich der Leiterplatte 2 zwischen den Anschlusspads 8 im Bereich der aufzubringenden Widerstandsschicht mit einer Füllschicht 10 versehen werden. Auf diese Weise wird eine ebene Trägeroberfläche für die Widerstandsschicht geschaffen. Ein stufenartiger Übergangsbereich im Randbereich der Anschlusspads 8 wird so vermieden.

Eine weitere Möglichkeit, einen solchen Übergangsbereich zu optimieren, kann realisiert werden, indem die Anschlusspads in z.B. vorgefräste Ausnehmungen der Leiterplatte eingebettet werden (nicht dargestellt). Auch hierdurch wird eine ebene Trägeroberfläche für die Widerstandsschicht erzielt.

Bei einem der Carbonschicht von 0,002 m/Ωmm², einer Schichtdicke von 30 µm und einer Widerstandsgröße von 7*20 mm ergibt sich ein Widerstandswert von ca. 47 Ω. Die aktive Masse des Widerstands 6 beträgt bei einer Dichte von 1,55 g/cm³ dabei ca. 6,5 mg. Bei einer zulässigen kurzzeitigen Grenztemperatur von etwa 300 °C ergibt sich dabei ein rechnerisches, rein adiabates Absorptionsvermögen von ca. 1,6 Ws. Dies entspricht einem Stromimpuls von ca. 36 A bei der eingangs genannten Kurvenform bzw. einer Surgebelastung von ca. 2500 V. Empirische ermittelte Werte ergeben jedoch aufgrund der sehr guten thermischen Kopplung der Carbonschicht an die Leiterplatte 2 eine deutlich höhere Impulsbelastbarkeit.

Der Schwachpunkt bildet in der Praxis die Terminierung der Carbonschicht, d.h. die Anbindung der Widerstandsschicht an die Kupferschicht der Leiterplatte. Wie aus der Einzelheit in Fig. 3 ersichtlich ist, tritt beim Übergang der Carbondruckschicht von der Kupferschicht des Anschlusspads 8 auf den Leiterplattenträger 2 eine Stufe auf. Dadurch wird die wirksame Widerstandsschicht an dieser Stelle reduziert und damit die Impulsbelastbarkeit stark herabgesetzt. Außerdem kann durch das Druckverfahren an dieser Stelle keine optimale Homogenität der Schicht erreicht werden.

Die Querschnittsverjüngung kann durch die Verwendung einer Leiterplatte 2 mit möglichst dünner Kupferplattierung (z.B. 17 µm statt der 35 Standardbeschichtung) sowie einer Bedruckung der Zwischenfläche mit einer der Kupferdicke entsprechenden Zwischenschicht, z.B. einem üblichen Lötstoplack, reduziert werden.

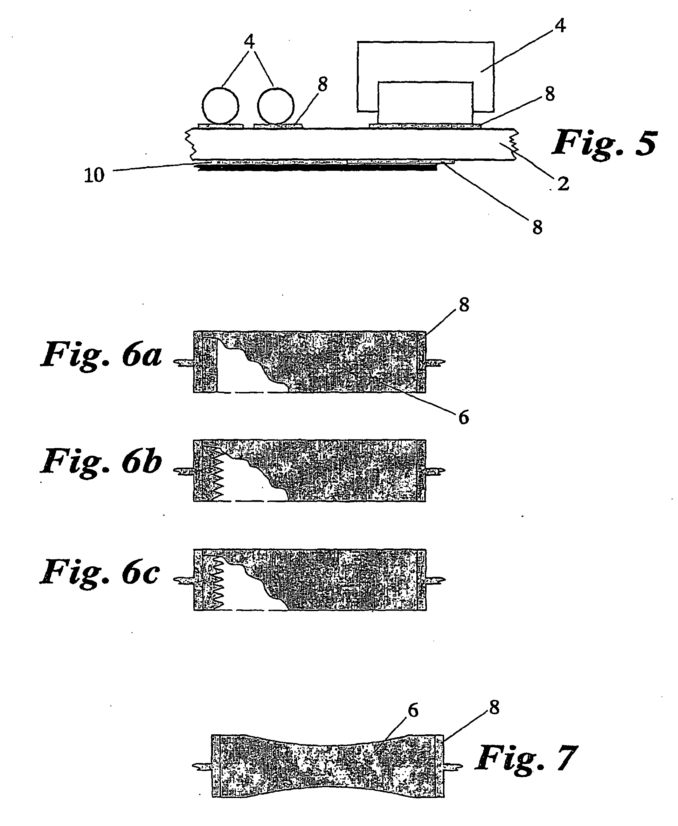

Des Weiteren kann die Übergangsfläche von der Kupferfläche auf die Widerstandsschicht durch eine gezackte (Fig.6b) oder wellenförmige (Fig.6c) Ausformung des Anschlusspads 8 vergrößert werden.

Eine weitere Möglichkeit die Terminierung zu entlasten, besteht durch eine Verjüngung der Widerstandsschicht zur Mitte des Widerstands 6. Durch die Verjüngung kann der Widerstandswert erhöht werden, was zu einem geringeren Impulsstrom führt, oder es kann die wirksame Breite der Terminierung bei gleichem Widerstandswert vergrößert werden.

Femer ist der Einsatz der Erfindung nicht auf die Verwendung eines Carbonlacks begrenzt. Im Prinzip sind alle möglichen Widerstandspasten, die eine niedrige Einbrenn- bzw. Trockentemperatur benötigen (< 200 °C), verwendbar. Der Nennwert des Widerstandes kann durch die Geometrie der Bedruckung in einem weiten Bereich beeinflußt werden, jedoch stellt das angegebene Beispiel einen sehr guten Kompromiß zwischen der Impulsbelastbarkeit (hier ca. 4 kV) und der Verlustleistung des Widerstands im Nennbetrieb dar. So liegt die Verlustleistung bei einer erfindungsgemäßen elektronischen Baueinheit mit einer Leistungsaufnahme von 10 VA bei ca. 100mW. Kann der Widerstandsnennwert erhöht werden, z.B. bei einer elektronischen Baugruppe mit geringerer Leistungsaufnahme, so kann die Masse, d.h. die Fläche, des Carbondrucks reduziert werden. Der Widerstandsnennwert läßt sich dabei durch eine Reduzierung des Leitwerts des Carbonlacks durch Abmischen mit Isolierpasten erreichen.

### Bezugszeichenliste

- 2: Leiterplatte
- 4: Bauelement
- 6: Widerstand
- 8: Anschlusspad
- 10: Füllschicht

## Patentansprüche

1. Elektronische Baueinheit, insbesondere für elektrische Schaltgeräte mit geringer Leistungsaufnahme wie Schütze, Zeitrelais oder dergleichen,
- umfassend eine Leiterplatte (2) mit Leiterbahnen und Anschlusspads (8),
- wobei die Leiterplatte (2) mit Halbleiterbauelementen (4) und zumindest einem ohmschen Widerstand (6) zur Begrenzung von impulsförmigen Eingangsströmen bestückt ist,
**dadurch gekennzeichnet,**
- **dass** der zumindest eine ohmsche Widerstand (6) in Form einer aufgedruckten Widerstandsschicht ausgebildet ist und
- in dem Bereich der Leiterplatte (2) zwischen den Anschlusspads (8) der Leiterbahnen für den Widerstand (6) im Bereich der Widerstandsschicht eine Füllschicht (10), insbesondere Lötstoplackschicht, angeordnet ist derart, dass der Leiterplattenbereich für die Widerstandsschicht einschließlich der Anschlusspads (8) eine übergangsfreie Ebene bildet.

2. Elektronische Baueinheit, insbesondere für elektrische Schaltgeräte mit geringer Leistungsaufnahme wie Schütze, Zeitrelais oder dergleichen,
- umfassend eine Leiterplatte (2) mit Leiterbahnen und Anschlusspads (8),
- wobei die Leiterplatte (2) mit Halbleiterbauelementen (4) und zumindest einem ohmschen Widerstand (6) zur Begrenzung von impulsförmigen Eingangsströmen bestückt ist,
**dadurch gekennzeichnet,**
- **dass** der zumindest eine ohmsche Widerstand (6) in Form einer aufgedruckten Widerstandsschicht ausgebildet ist und
- **dass** die Anschlusspads (8) zum Anschluß der Widerstandsschicht in Ausnehmungen der Leiterplatte (2) eingelassen sind derart, dass der Leiterplattenbereich für die Widerstandsschicht einschließlich der Anschlusspads (8) eine übergangsfreie Ebene bildet.

3. Elektronische Baueinheit nach vorstehendem Anspruch, **dadurch gekennzeichnet, dass** die Widerstandsschicht aus einem Carbonleitlack, insbesondere Einkomponenten Carbonleitlack, besteht.

4. Elektronische Baueinheit nach einem der vorherigen Ansprüche, **dadurch gekennzeichnet, dass** die Leiterplattenpads (8) im Anschlußbereich oberflächenvergrößemd, insbesondere gezackt oder wellenförmig, ausgeformt ist.

5. Elektronische Baueinheit nach einem der vorherigen Ansprüche, **dadurch gekennzeichnet, dass** die Widerstandsschicht im Bereich zwischen den Anschlusspads (8) verjüngend ausgebildet ist.

6. Elektronische Baueinheit nach einem der vorherigen Ansprüche, **dadurch gekennzeichnet, dass** die Leiterplatte (2) derart bestückt ist, dass eine Leiterplattenseite mit diskreten Bauteilen insbesondere ausschließlich SMD-Bauteile und die andere Leiterplattenseite mit der Widerstandsschicht versehen ist.

7. Verfahren zur Herstellung eines massereichen ohmschen Vorwiderstandes mit großer Impulsfestigkeit, **dadurch gekennzeichnet, dass**
- auf eine Leiterplatte (2) mit zumindest zwei Anschlusspads (8) eine Widerstandsschicht aufgebracht wird,
- wobei im Bereich der Widerstandsschicht zwischen den Anschlusspads (8) der Leiterbahnen für den Widerstand (6) eine Füllschicht, insbesondere Lötstoplackschicht, angeordnet ist derart, dass der Leiterplattenbereich für die Widerstandsschicht einschließlich der Anschlusspads (8) eine übergangsfreie Ebene bildet.

8. Verfahren zur Herstellung eines massereichen ohmschen Vorwiderstandes mit großer Impulsfestigkeit, **dadurch gekennzeichnet, dass**
- auf eine Leiterplatte (2) mit zumindest zwei Anschlusspads (8) eine Widerstandsschicht aufgebracht wird
- und die Anschlusspads (8) in Ausnehmungen der Leiterplatte (2) eingelassen werden derart, dass der Leiterplattenbereich für die Widerstandsschicht einschließlich der Anschlusspads (8) eine übergangsfreie Ebene bildet.

9. Verfahren nach einem der Ansprüche 7 oder 8, **dadurch gekennzeichnet, dass** die Widerstandsschicht im Siebdruckverfahren aufgebracht wird.

10. Verfahren nach einem der Ansprüche 7, 8 oder 9, **dadurch gekennzeichnet, dass** auf eine Leiterplatte (2) mit zumindest zwei Anschlusspads (8) eine Carbonschicht aufgebracht wird.

## Claims

1. Electronic unit, in particular for low power-consumption electrical switching devices such as contactors, timing relays or the like,
- comprising a printed circuit board (2) with conductor tracks and connecting pads (8),
- with the printed circuit board (2) being fitted with semiconductor components (4) and with at least one non-reactive resistor (6) for limiting pulsed input currents,
**characterized**
- **in that** the at least one non-reactive resistor (6) is in the form of a printed resistance layer, and
- a filling layer (10), in particular a solder stop varnish layer, is arranged in the area of the printed circuit board (2) between the connecting pads (8) of the conductor tracks for the resistor (6) in the area of the resistance layer, such that the printed circuit board area for the resistance layer, including the connecting pads (8), forms a plane without any steps.

2. Electronic unit, in particular for low power-consumption electrical switching devices such as contactors, timing relays or the like,
- comprising a printed circuit board (2) with conductor tracks and connecting pads (8),
- with the printed circuit board (2) being fitted with semiconductor components (4) and with at least one non-reactive resistor (6) for limiting pulsed input currents,
**characterized**
- **in that** the at least one non-reactive resistor (6) is in the form of a printed resistance layer, and
- **in that** the connecting pads (8) for connection of the resistance layer are incorporated in recesses in the printed circuit board (2) such that the printed circuit board area for the resistance layer, including the connecting pads (8), forms a plane without any steps.

3. Electronic unit according to the preceding claim, **characterized in that** the resistance layer is composed of a carbon conductive varnish, in particular single-component carbon conductive varnish.

4. Electronic unit according to one of the preceding claims, **characterized in that** the printed circuit board pads (8) in the connecting area are formed such that they enlarge the surface area, in particular being zigzagged or corrugated.

5. Electronic unit according to one of the preceding claims, **characterized in that** the resistance layer tapers in the area between the connecting pads (8).

6. Electronic unit according to one of the preceding claims, **characterized in that** the printed circuit board (2) is populated such that one printed circuit board side is provided with discrete components, in particular exclusively SMD components, and the other printed circuit board side is provided with the resistance layer.

7. Method for production of a high-mass non-reactive series resistor with a high degree of pulse immunity,
**characterized**
**in that**
- a resistance layer is applied to a printed circuit board (2) with at least two connecting pads (8),
- with a filling layer, in particular a solder stop varnish layer, being arranged in the area of the resistance layer between the connecting pads (8) of the conductor tracks for the resistor (6) such that the printed circuit board area for the resistance layer, including the connecting pads (8), forms a plane without any steps.

8. Method for production of a high-mass non-reactive series resistor with a high degree of pulse immunity, **characterized**
**in that**
- a resistance layer is applied to a printed circuit board (2) with at least two connecting pads (8),
- and the connecting pads (8) are incorporated in recesses in the printed circuit board (2) such that the printed circuit board area for the resistance layer, including the connecting pads (8), forms a plane without any steps.

9. Method according to one of Claims 7 or 8,
**characterized in that** the resistance layer is applied using the screen-printing method.

10. Method according to one of Claims 7, 8 or 9, **characterized in that** a carbon layer is applied to a printed circuit board (2) with at least two connecting pads (8).

## Revendications

1. Module électronique, notamment pour des appareillages électriques à faible consommation tels que les contacteurs, les relais temporisés ou similaires, comprenant un circuit imprimé (2) avec des pistes conductrices et des pastilles de raccordement (8), le circuit imprimé (2) étant équipé de composants semiconducteurs (4) et d'au moins une résistance ohmique (6) pour limiter les courants d'entrée impulsionnels, **caractérisé en ce**
- **que** l'au moins une résistance ohmique (6) est réalisée sous la forme d'une couche résistive imprimée et
- dans la zone du circuit imprimé (2), entre les pastilles de raccordement (8) des pistes conductrices pour la résistance (6), dans la zone de la couche résistive, est disposée une couche de remplissage (10), notamment une couche de vernis d'arrêt de soudure, de telle sorte que la zone du circuit imprimé destinée à la couche résistive forme, avec les pastilles de raccordement (8), un plan continu.

2. Module électronique, notamment pour des appareillages électriques à faible consommation tels que les contacteurs, les relais temporisés ou similaires, comprenant un circuit imprimé (2) avec des pistes conductrices et des pastilles de raccordement (8), le circuit imprimé (2) étant équipé de composants semiconducteurs (4) et d'au moins une résistance ohmique (6) pour limiter les courants d'entrée impulsionnels, **caractérisé en ce**
- **que** l'au moins une résistance ohmique (6) est réalisée sous la forme d'une couche résistive imprimée et
- **que** les pastilles de raccordement (8) destinées au raccordement de la couche résistive sont encastrées dans des creux du circuit imprimé (2) de telle sorte que la zone du circuit imprimé destinée à la couche résistive forme, avec les pastilles de raccordement (8), un plan continu.

3. Module électronique selon la revendication précédente, **caractérisé en ce que** la couche résistive se compose d'un vernis conducteur au carbone, notamment d'un vernis conducteur au carbone monocomposant.

4. Module électronique selon l'une des revendications précédentes, **caractérisé en ce que** les pastilles de raccordement du circuit imprimé (8) dans la zone de raccordement sont configurées de manière à ce que la surface soit agrandie, notamment de forme dentelée ou ondulée.

5. Module électronique selon l'une des revendications précédentes, **caractérisé en ce que** la couche résistive est configurée de manière à se rétrécir dans la zone entre les pastilles de raccordement (8).

6. Module électronique selon l'une des revendications précédentes, **caractérisé en ce que** le circuit imprimé (2) est équipé de telle sorte qu'un côté du circuit imprimé est équipé de composants discrets, notamment exclusivement des composants CMS, et l'autre côté du circuit imprimé est muni de la couche résistive.

7. Procédé de fabrication d'une résistance série ohmique de forte masse à grande résistance aux impulsions, **caractérisé en ce que**
- une couche résistive est appliquée sur un circuit imprimé (2) comprenant au moins deux pastilles de raccordement (8),
- une couche de remplissage, notamment une couche de vernis d'arrêt de soudure, étant disposée dans la zone de la couche résistive entre les pastilles de raccordement (8) des pistes conductrices pour la résistance (6) de telle sorte que la zone du circuit imprimé destinée à la couche résistive forme, avec les pastilles de raccordement (8), un plan continu.

8. Procédé de fabrication d'une résistance série ohmique de forte masse à grande résistance aux impulsions, **caractérisé en ce que**
- une couche résistive est appliquée sur un circuit imprimé (2) comprenant au moins deux pastilles de raccordement (8),
- et les pastilles de raccordement (8) sont encastrées dans des creux du circuit imprimé (2) de telle sorte que la zone du circuit imprimé destinée à la couche résistive forme, avec les pastilles de raccordement (8), un plan continu.

9. Procédé selon l'une des revendications 7 ou 8, **caractérisé en ce que** la couche résistive est appliquée par sérigraphie.

10. Procédé selon l'une des revendications 7, 8 ou 9, **caractérisé en ce qu'**une couche de carbone est appliquée sur un circuit imprimé (2) comprenant au moins deux pastilles de raccordement (8).
